# EUROPÄISCHE PATENTANMELDUNG

(11) **EP 2 979 783 A1**
(43) Veröffentlichungstag der Anmeldung: **03.02.2016**
(21) Anmeldenummer: 14178768.9
(22) Anmeldetag: 28.07.2014
(51) Int. Cl.: B22F 5/00, B22F 7/04, H05K 3/00, H01L 23/00

(54) **Verfahren zum Verbinden von Bauelementen durch Drucksintern**

(71) Anmelder: Heraeus Deutschland GmbH & Co. KG, 63450 Hanau (DE)
(72) Erfinder: Schäfer, Michael, 36093 Künzell (DE); Schmitt, Wolfgang, 63110 Rodgau (DE)
(74) Vertreter: Heraeus IP

(57) **Zusammenfassung**

Verfahren zum Verbinden von Bauelementen, bei dem man eine Anordnung aus wenigstens zwei Bauelementen mit einer aus metallischen Kontaktoberflächen der beiden Bauelemente gebildeten gemeinsamen Kontaktfläche bereitstellt und die Anordnung drucksintert, wobei die metallische Kontaktoberfläche wenigstens eines der beiden Bauelemente mit einer Metalloxidschicht bedeckt ist, und wobei (I) das Drucksintern in einer mindestens eine oxidierbare Verbindung enthaltenden Atmosphäre durchgeführt und/oder (II) die Metalloxidschicht vor Bildung der gemeinsamen Kontaktfläche mit mindestens einer oxidierbaren organischen Verbindung versehen wird.

## Beschreibung

Die Erfindung betrifft ein Verfahren zum Verbinden von Bauelementen durch Drucksintern.

In der Elektronikindustrie ist die Verwendung von Metallsinterpasten oder von daraus durch Applikation und Trocknung hergestellten sinterfähigen Sintervorformen (sogenannte sinter preforms) zur Befestigung und elektrischen Kontaktierung von und zur Wärmeabfuhr aus Elektronikbauteilen wie beispielsweise Halbleiterchips bekannt. So sind solche Metallsinterpasten und Sintervorformen beispielsweise am 17. Januar 2014 in der online-Publikation "Are Sintered Silver Joints Ready for Use as Interconnect Material in Microelectronic Packaging?" des Autors KIM S. SIOW im Journal of ELECTRONIC MATERIALS (DOI: 10.1007/s11664-013-2967-3) beschrieben. Beispiele für Patentliteratur zu Metallsinterpasten sind WO2011//026623A1, EP2425920A1, EP2428293A1 und EP2572814A1. Üblicherweise werden solche Metallsinterpasten durch Drucken, beispielsweise Sieb- oder Schablonendruck, auf Trägersubstrate aufgebracht, gegebenenfalls getrocknet, mit Elektronikbauteilen bestückt und dann einem Sintervorgang unterworfen. Ohne den flüssigen Zustand zu durchlaufen, verbinden sich die Metallteilchen während des Sinterns durch Diffusion unter Ausbildung einer festen, elektrischen Strom und Wärme leitenden metallischen Verbindung zwischen Träger und Elektronikbauteil.

Wie von der Anmelderin festgestellt werden konnte, kann eine Befestigung zwischen Bauelementen unter Ausbildung einer Sinterverbindung allerdings auch ohne oder ohne direkte Verwendung einer Metallsinterpaste erzielt werden.

Die Erfindung betrifft ein Verfahren zum Verbinden von Bauelementen, bei dem man eine Anordnung aus wenigstens zwei Bauelementen mit einer aus metallischen Kontaktoberflächen der beiden Bauelemente gebildeten gemeinsamen Kontaktfläche bereitstellt und die Anordnung drucksintert, wobei die metallische Kontaktoberfläche wenigstens eines der beiden Bauelemente mit einer Metalloxidschicht bedeckt ist, und wobei (I) das Drucksintern in einer mindestens eine oxidierbare Verbindung enthaltenden Atmosphäre durchgeführt und/oder (II) die Metalloxidschicht vor Bildung der gemeinsamen Kontaktfläche mit mindestens einer oxidierbaren organischen Verbindung versehen wird.

Das erfindungsgemäße Verfahren in der Ausführungsform (I) umfasst demgemäß die Schritte:
(i) Bereitstellen wenigstens zweier Bauelemente jeweils mit metallischer Kontaktoberfläche, wobei die metallische Kontaktoberfläche wenigstens eines der beiden Bauelemente mit einer Metalloxidschicht bedeckt ist,
(ii) Bereitstellen einer Anordnung aus den wenigstens zwei Bauelementen unter Bildung einer gemeinsamen Kontaktfläche aus metallischen Kontaktoberflächen der beiden Bauelemente, und
(iii) Drucksintern der Anordnung in einer mindestens eine oxidierbare Verbindung enthaltenden Atmosphäre.

Das erfindungsgemäße Verfahren in der Ausführungsform (II) umfasst hingegen die Schritte:
(i) Bereitstellen wenigstens zweier Bauelemente jeweils mit metallischer Kontaktoberfläche, wobei die metallische Kontaktoberfläche wenigstens eines der beiden Bauelemente mit einer Metalloxidschicht bedeckt ist,
(ii) Versehen der Metalloxidschicht mit mindestens einer oxidierbaren organischen Verbindung,
(iii) Bereitstellen einer Anordnung aus den wenigstens zwei Bauelementen unter Bildung einer gemeinsamen Kontaktfläche aus metallischen Kontaktoberflächen der beiden Bauelemente, und
(iv) Drucksintern der Anordnung.

Es ist möglich, die Ausführungsformen (I) und (II) zu kombinieren.

Beim erfindungsgemäßen Verfahren werden wenigstens zwei Bauelemente miteinander verbunden. Dabei wird eine Anordnung aus wenigstens zwei Bauelementen mit einer aus metallischen Kontaktoberflächen der beiden Bauelemente gebildeten gemeinsamen Kontaktfläche bereitgestellt und diese Anordnung in üblicher, dem Fachmann bekannter Weise unter Anwendung von mechanischem Druck und erhöhter Temperatur gesintert, wobei eine oder beide der an der Bildung der gemeinsamen Kontaktfläche beteiligten metallischen Kontaktoberflächen eine Metalloxidschicht aufweisen bzw. damit bedeckt sind.

Unter dem Verbinden von wenigstens zwei Bauelementen wird das Befestigen von einem ersten Bauelement auf einem zweiten Bauelement verstanden. Im Rahmen der vorliegenden Erfindung bedeutet "auf" lediglich, dass eine metallische Kontaktoberfläche des ersten Bauelements mit einer metallischen Kontaktoberfläche des zweiten Bauelements verbunden wird, wobei es auf die relative Lage der Bauelemente oder der Anordnung, die die Bauelemente umfasst, nicht ankommt.

Im Rahmen der Erfindung soll der Begriff Bauelement vorzugsweise Einzelteile umfassen. Diese Einzelteile sind vorzugsweise nicht weiter zerlegbar.

Gemäß besonderen Ausführungsformen werden als Bauelemente Teile bezeichnet, die in der Elektronik verwendet werden. Demgemäß kann es sich bei den Bauelementen beispielsweise um aktive Bauelemente (z.B. Halbleiterchips wie LEDs, Dioden, IGBTs, Thyristoren, MOSFETs, Transistoren, ICs), passive Bauteile (z.B. DCBs, Leadframes, Widerstände, Kondensatoren, Spulen, Induktivitäten, Memristoren, Clips, Kühlkörper), Piezokeramiken und Peltierelemente handeln.

Die zu verbindenden Bauelemente können gleichartige oder verschiedenartige Bauelemente sein.

Die Bauelemente haben jeweils eine metallische Kontaktoberfläche, wobei das Metall der metallischen Kontaktoberfläche ein reines Metall oder eine Metalllegierung sein kann. Die Legierungen weisen beispielsweise einen Anteil von > 50 Gew.-% des betreffenden Metalls auf.

Das Metall der metallischen Kontaktoberfläche wenigstens eines der zu verbindenden Bauelemente ist bevorzugt ausgewählt aus der aus Silber, Kupfer, Palladium und Legierungen dieser Metalle bestehenden Gruppe. Silber und Silberlegierungen sind besonders bevorzugt als Metall der metallischen Kontaktoberfläche.

Das oder die Bauelemente können als solche aus dem Metall der metallischen Kontaktoberfläche bestehen oder ihre metallische Kontaktoberfläche kann beispielsweise in Form einer Metallisierung vorliegen. Beispielsweise kann es sich um eine durch Aufdampfen, chemische Galvanisierung, Elektrogalvanisierung oder durch Applikation aus einer Metallsinterzubereitung mit anschließendem Sintern hergestellte Metallisierung handeln. Beispiele für Metallsinterzubereitungen sind die eingangs schon erwähnten Metallsinterpasten.

Im Falle eines nicht ohnehin aus dem Metall bestehenden Bauelementes kann die metallische Kontaktoberfläche beispielsweise 100 nm bis 200 µm dick sein.

Wie schon gesagt, ist die metallische Kontaktoberfläche wenigstens eines der zu verbindenden Bauelemente mit einer Metalloxidschicht bedeckt, insbesondere mit einer Metalloxidschicht aus dem betreffenden Metall. Die äußere oder nach außen weisende Metalloxidschicht ist fest mit dem darunter befindlichen Metall verbunden. Die Metalloxidschicht kann beispielsweise 0,02 bis 6 µm dick sein. Sie kann durch Oxidation, insbesondere durch Oxidation des betreffenden Metalls, beispielsweise bei Luftkontakt gebildet oder chemisch mittels Oxidationsmitteln oder durch anodische Oxidation der nicht, noch nicht, gering oder mehr oder minder stark oxidierten metallischen Kontaktoberfläche hergestellt oder verstärkt werden. Wie im vorhergehenden Satz schon angedeutet, kann eine schon vorhandene dünne Schicht des Metalloxids beispielsweise mittels anodischer Oxidation erzeugt oder verstärkt werden. Beispielsweise kann eine nicht, teilweise oder anoxidierte Metallkontaktoberfläche anodisch oxidiert werden bis zur Ausbildung einer Metalloxidschichtdicke von beispielsweise 0,03 bis 5 µm. Im Falle einer Silberkontaktoberfläche kann eine Silberoxidschicht mit einer Schichtdicke von beispielsweise 0,05 bis 1 µm durch anodische Oxidation ausgebildet werden.

Die anodische Oxidation kann beispielsweise durch Eintauchen der als Anode geschalteten und zu oxidierenden metallischen Kontaktoberfläche des betreffenden Bauelements oder gegebenenfalls des Bauelements selber in eine geeignete wässrige Elektrolytlösung durchgeführt werden. Als wässrige Elektrolytlösungen eignen sich beispielsweise wässrige 5 bis 10 gew.-%ige Lösungen von Natriumcarbonat, Natriumhydrogencarbonat, Kaliumhydroxid oder Natriumhydroxid. Die anodische Oxidation kann beispielsweise für 5 bis 30 Sekunden bei einer Gleichspannung im Bereich von 5 bis 20 Volt durchgeführt werden.

Im erfindungsgemäßen Verfahren werden Bauelemente durch Drucksintern miteinander verbunden, d.h. die Bauelemente werden durch Erhitzen und unter Anwendung mechanischen Drucks ohne, dass das bzw. die Metalle der die gemeinsame Metallkontaktfläche bildenden Kontaktoberflächen der Bauelemente die flüssige Phase erreichen, miteinander verbunden.

In Ausführungsform (I) des erfindungsgemäßen Verfahrens findet das Drucksintern in einer mindestens eine oxidierbare Verbindung enthaltenden Atmosphäre statt. Beispiele für geeignete oxidierbare Verbindungen sind Kohlenmonoxid, Wasserstoff und Ameisensäure.

Die Atmosphäre kann aus der mindestens einen oxidierbaren und gasförmig vorliegenden Verbindung bestehen oder letztere in Kombination mit inerten Gasen wie insbesondere Stickstoff und/oder Argon enthalten. Bevorzugt beträgt der Anteil an oxidierbaren Verbindungen in der Atmosphäre 1 bis 30 Volumen-%.

In Ausführungsform (II) des erfindungsgemäßen Verfahrens werden die Metalloxidschicht oder - falls die metallischen Kontaktoberflächen beider Bauelemente eine Metalloxidschicht aufweisen - bevorzugt sogar beider Metalloxidschichten vor Bildung der gemeinsamen Kontaktfläche mit mindestens einer, d.h. mit einer oder einer Mischung zweier oder mehrerer oxidierbarer organischer Verbindungen versehen.

Die oxidierbaren organischen Verbindungen weisen bevorzugt 1 bis 50, mehr bevorzugt 2 bis 24, noch mehr bevorzugt 6 bis 24 und noch mehr bevorzugt 8 bis 20 Kohlenstoffatome auf und haben wenigstens eine funktionelle Gruppe.

Vorzugsweise kommen als oxidierbare organische Verbindungen freie Fettsäuren, Fettsäuresalze oder Fettsäureester zum Einsatz. Die freien Fettsäuren, Fettsäuresalze und Fettsäureester sind vorzugsweise unverzweigt. Ferner sind die freien Fettsäuren, Fettsäuresalze oder Fettsäureester vorzugsweise gesättigt.

Bevorzugte Fettsäuresalze sind die Salze von Ammonium, Monoalkylammonium, Dialkylammonium, Trialkylammonium, Aluminium, Kupfer, Lithium, Natrium und Kalium.

Bevorzugte Ester sind Alkylester, insbesondere Methylester, Ethylester, Propylester und Butylester.

Gemäß einer bevorzugten Ausführungsform handelt es sich bei den freien Fettsäuren, Fettsäuresalzen oder Fettsäureestern um Verbindungen mit 8 bis 24, mehr bevorzugt 8 bis 18 Kohlenstoffatomen.

Bevorzugte oxidierbare organische Verbindungen sind Caprylsäure (Octansäure), Caprinsäure (Decansäure), Laurinsäure (Dodecansäure), Myristinsäure (Tetradecansäure), Palmitinsäure (Hexadecansäure), Margarinsäure (Heptadecansäure), Stearinsäure (Octadecansäure), Arachinsäure (Eicosansäure/Icosansäure), Behensäure (Docosansäure), Lignocerinsäure (Tetracosansäure) sowie die entsprechenden Ester und Salze.

Besonders bevorzugte oxidierbare organische Verbindungen sind Dodecansäure, Octadecansäure, Aluminiumstearat, Kupferstearat, Natriumstearat, Kaliumstearat, Natriumpalmitat und Kaliumpalmitat.

Um die Metalloxidschicht oder -schichten mit der mindestens einen oxidierbaren organischen Verbindung zu versehen, kann letztere beispielsweise unverdünnt als Wirksubstanz oder aus einer wässrigen Zubereitung oder aus einer Zubereitung in organischem Lösemittel auf die Oberfläche der Metalloxidschicht aufgetragen werden, gefolgt von einer Trocknung beispielsweise bei einer Objekttemperatur von 15 bis 50 °C während einer Trocknungsdauer von 10 bis 60 Minuten. Hinsichtlich der Auftragsart gibt es keine prinzipielle Beschränkung; beispielsweise kann die Metalloxidschicht in die Zubereitung der mindestens einen oxidierbaren organischen Verbindung eingetaucht werden oder die Zubereitung der mindestens einen oxidierbaren organischen Verbindung kann auf die Metalloxidschicht aufgesprüht oder aufgepinselt werden. Bei der wässrigen Zubereitung oder der Zubereitung auf Basis organischen Lösemittels kann es sich um eine beispielsweise 1 bis 20 gew.-%ige Lösung, Dispersion oder Suspension der mindestens einen oxidierbaren organischen Verbindung handeln.

Das Verhältnis der Masse der mindestens einen oxidierbaren organischen Verbindung zur Fläche der mit der mindestens einen oxidierbaren organischen Verbindung zu versehenden bzw. versehenen Metalloxidschicht beträgt beispielsweise 0,0005 bis 10 g der mindestens einen oxidierbaren organischen Verbindung pro Quadratmeter Metalloxidfläche. Der Fachmann wird dieses Verhältnis angelehnt an die Metalloxidschichtdicke wählen, d.h. je höher die Metalloxidschichtdicke ist, je höher wird er das Verhältnis der Masse der mindestens einen oxidierbaren organischen Verbindung zur Fläche der mit der mindestens einen oxidierbaren organischen Verbindung zu versehenden Metalloxidschicht wählen.

Zwecks Herstellung der gemeinsamen Kontaktfläche wird ein Bauelement mit seiner metallischen Kontaktoberfläche auf die metallische Kontaktoberfläche des anderen Bauelements aufgesetzt. Der Überlappungsbereich der metallischen Kontaktoberflächen oder Flächenanteile derselben definiert dabei die gemeinsame Kontaktfläche. Zur Vermeidung jeglicher Unklarheit sei noch einmal ausdrücklich betont, dass dabei im Falle der Ausführungsform (II) mindestens eine der in Rede stehenden metallischen Kontaktoberflächen eine mit der mindestens einen oxidierbaren organischen Verbindung versehene Metalloxidschicht aufweist.

Die Anordnung aus den wenigstens zwei Bauelementen wird schließlich einem Drucksinterprozess unterworfen.

Das eigentliche Drucksintern erfolgt bei einer Objekttemperatur von beispielsweise 200 bis 280 °C und der Prozessdruck liegt beispielsweise im Bereich von 1 bis unter 40 MPa, bevorzugt 5 bis 20 MPa. Die Sinterzeit liegt beispielsweise im Bereich von 1 bis 5 Minuten.

Falls ausschließlich gemäß der Ausführungsform (II) gearbeitet wird, kann das Drucksintern in einer Atmosphäre erfolgen, die keinen besonderen Beschränkungen unterliegt, mit Ausnahme dessen, dass sie verschieden von der bei der Ausführungsform (I) vorherrschenden Atmosphäre ist. Beispielsweise kann bei der Ausführungsform (II) eine Atmosphäre vorherrschen, die Sauerstoff enthält, oder es handelt sich um eine sauerstofffreie Atmosphäre. Unter sauerstofffreier Atmosphäre ist im Rahmen der Erfindung eine Atmosphäre, insbesondere eine Inertgasatmosphäre beispielsweise aus Stickstoff und/oder Argon, zu verstehen, deren Sauerstoffgehalt nicht mehr als 500 ppm, vorzugsweise nicht mehr als 10 ppm und noch mehr bevorzugt nicht mehr als 1 ppm beträgt.

Das Drucksintern wird in einer herkömmlichen, zum Drucksintern geeigneten Vorrichtung durchgeführt, in der sich die vorstehend beschriebenen Prozessparameter einstellen lassen.

Falls die metallischen Kontaktoberflächen der zu verbindenden Bauelemente das gleiche Metall aufweisen, kommt es zur Ausbildung einer entsprechenden Metall-Sinterverbindung; anderenfalls wird mit dem erfindungsgemäßen Verfahren eine Sinterverbindung des Typs Metall1/Metall2 zwischen den Bauelementen geschaffen.

### Ausführungsbeispiel 1

Auf ein eine Goldoberfläche aufweisendes DCB-Substrat wurde eine 10 x 10 mm² große Schicht aus einer Silbersinterpaste (ASP 043-04P2 von Heraeus Materials Technology) in einer Nassschichtdicke von 50 µm mittels Schablonendruck aufgebracht und danach 30 min im Umlufttrockenschrank bei 250 °C Objekttemperatur gesintert.

In einem Edelstahlgefäß wurde eine 10 gew.-%ige wässrige Lösung von Natriumcarbonat vorgelegt und das Edelstahlgefäß mit der Kathode einer 10 V-Gleichspannungsquelle verbunden. Die Anode der Spannungsquelle wurde mit der auf dem DCB-Substrat zuvor hergestellten Silberoberfläche verbunden und für 30 Sekunden in die Natriumcarbonatlösung eingetaucht. Nach dem Austauchen wurde die infolge anodischer Oxidation schwarz verfärbte Silberoberfläche mit deionisiertem Wasser gespült und das DCB-Substrat getrocknet. Anschliessend wurde ein Tropfen einer 2 gew.-%igen Laurinsäurelösung in Exxsol™ D60 auf die Silberoxidschicht gegeben, gleichmäßig verteilt und bei 70 °C im Umlufttrockenschrank getrocknet. Danach wurde ein 10 x 10 mm² großer IGBT mit seiner Silberkontaktfläche auf die mit Laurinsäure versehene Silberoxidschicht aufgesetzt und für 120 Sekunden bei 250 °C Objekttemperatur und einem mechanischen Druck von 20 MPa in einer Sinterpresse mit dem DCB-Substrat versintert.

### Ausführungsbeispiel 2

In einem Edelstahlgefäß wurde eine 10 gew.-%ige wässrige Lösung von Natriumcarbonat vorgelegt und das Edelstahlgefäß mit der Kathode einer 10 V-Gleichspannungsquelle verbunden. Die Anode der Spannungsquelle wurde mit einem 3 cm langen, 3 mm breiten und 0,1 mm dicken Silberband der Fa. Schlenk Metallfolien verbunden und letzteres für 30 Sekunden in die Natriumcarbonatlösung eingetaucht.

Nach dem Austauchen wurde die infolge anodischer Oxidation schwarz verfärbte Silberoberfläche mit deionisiertem Wasser gespült und das Silberband getrocknet. Anschliessend wurde das Silberband in eine 2 gew.-%ige Laurinsäurelösung in Exxsol™ D60 getaucht und nach dem Austauchen bei 70 °C im Umlufttrockenschrank getrocknet. Danach wurde ein 2 x 2 mm² großer Si-Chip mit seiner Silberkontaktfläche auf die mit Laurinsäure versehene Silberoxidschicht aufgesetzt und für 120 Sekunden bei 250 °C Objekttemperatur und einem mechanischen Druck von 20 MPa in einer Sinterpresse mit dem Silberband versintert.

Nach dem Sintern wurde die Haftung über die Scherfestigkeit bestimmt. Dabei wurden die Bauelemente mit einem Schermeißel bei einer Geschwindigkeit von 0,3 mm/s bei 20 °C abgeschert. Die Kraft wurde mittels einer Kraftmessdose aufgenommen (Gerät DAGE 2000 der Firma DA-GE, Deutschland). Tabelle 1 zeigt die mit den Ausführungsbeispielen 1 bis 2 erhaltenen Ergebnisse.

**Tabelle 1**

| Ausführungsbeispiel | 1 | 2 |
|---|---|---|
| Scherfestigkeit (N/mm²) | 35 | 40 |

## Patentansprüche

1. Verfahren zum Verbinden von Bauelementen, bei dem man eine Anordnung aus wenigstens zwei Bauelementen mit einer aus metallischen Kontaktoberflächen der beiden Bauelemente gebildeten gemeinsamen Kontaktfläche bereitstellt und die Anordnung drucksintert, wobei die metallische Kontaktoberfläche wenigstens eines der beiden Bauelemente mit einer Metalloxidschicht bedeckt ist, und wobei (I) das Drucksintern in einer mindestens eine oxidierbare Verbindung enthaltenden Atmosphäre durchgeführt und/oder (II) die Metalloxidschicht vor Bildung der gemeinsamen Kontaktfläche mit mindestens einer oxidierbaren organischen Verbindung versehen wird.

2. Verfahren nach Anspruch 1, wobei es sich bei den Bauelementen um in der Elektronik verwendete Teile handelt.

3. Verfahren nach Anspruch 1 oder 2, wobei das Metall der metallischen Kontaktoberfläche wenigstens eines der zu verbindenden Bauelemente ausgewählt ist aus der aus Silber, Kupfer, Palladium und Legierungen dieser Metalle bestehenden Gruppe.

4. Verfahren nach einem der vorhergehenden Ansprüche, wobei die Metalloxidschicht durch Luftkontakt gebildet oder chemisch mittels Oxidationsmitteln oder durch anodische Oxidation hergestellt oder verstärkt worden ist.

5. Verfahren nach einem der vorhergehenden Ansprüche, wobei es sich bei der mindestens einen oxidierbaren organischen Verbindung um eine 1 bis 50 Kohlenstoffatome aufweisende organische Verbindung mit wenigstens einer funktionellen Gruppe handelt.

6. Verfahren nach einem der vorhergehenden Ansprüche, wobei das Verhältnis der Masse der mindestens einen oxidierbaren organischen Verbindung zur Fläche der Metalloxidschicht 0,0005 bis 10 g pro Quadratmeter Metalloxidfläche beträgt.

7. Verfahren nach einem der vorhergehenden Ansprüche, wobei die mindestens eine oxidierbare organische Verbindung ausgewählt ist unter freien Fettsäuren, Fettsäuresalzen und Fettsäureestern.

8. Verfahren nach einem der vorhergehenden Ansprüche, wobei die mindestens eine oxidierbare organische Verbindung aus einer wässrigen Zubereitung oder aus einer Zubereitung in organischem Lösemittel auf die Metalloxidschicht aufgebracht wird.

9. Verfahren nach Anspruch 8, wobei es sich bei der Zubereitung um eine Lösung, Dispersion oder Suspension handelt.

10. Verfahren nach einem der vorhergehenden Ansprüche, wobei die metallische Kontaktoberfläche beider Bauelemente mit einer Metalloxidschicht bedeckt ist und beide Metalloxidschichten vor Bildung der gemeinsamen Kontaktfläche mit mindestens einer oxidierbaren organischen Verbindung versehen werden.

11. Nach einem Verfahren eines der vorhergehenden Ansprüche hergestellte Verbindung von Bauelementen.
